# EUROPÄISCHE PATENTANMELDUNG

(11) **EP 3 030 058 A2**
(43) Veröffentlichungstag der Anmeldung: **08.06.2016**
(21) Anmeldenummer: 15197810.3
(22) Anmeldetag: 03.12.2015
(51) Int. Cl.: H05K 1/02

(54) **LEITERPLATTE FÜR EINE KRAFTFAHRZEUGBELEUCHTUNGSEINRICHTUNG MIT OPTIMIERTER ENTWÄRMUNG**

(30) Priorität: 03.12.2014 DE 102014224732
(71) Anmelder: Automotive Lighting Reutlingen GmbH, 72762 Reutlingen (DE)
(72) Erfinder: Temme, Jürgen, 72127 Kusterdingen-Immenhausen (DE); Schöning, Michael, 37154 Northeim (DE); Kutschat, Jürgen, 72581 Dettingen (DE)
(74) Vertreter: DREISS Patentanwälte PartG mbB

(57) **Zusammenfassung**

Vorgestellt wird eine Leiterplatte für Kraftfahrzeugbeleuchtungseinrichtungen, die einen Schichtstapel mit mehreren Metallschichten und mehreren dielektrischen Schichten aufweist. Erste metallische Durchkontaktierungen dienen zur thermischen Verbindung einer dritten mit einer zweiten Metallschicht. Zweite metallische Durchkontaktierungen dienen zur thermischen Verbindung der zweiten und einer ersten Metallschicht. Die Beleuchtungseinrichtung zeichnet sich durch fünf erste Durchkontaktierungen und vier zweite Durchkontaktierungen aus, wobei vier erste Durchkontaktierungen Eckpunkte eines ersten Rechtecks bilden, die fünfte der ersten Durchkontaktierungen im Schnittpunkt der Diagonalen des ersten Rechtecks liegt, und die vier zweiten Durchkontaktierungen auf den Eckpunkten eines zweiten Rechtecks liegen, wobei jeweils ein Eckpunkt des zweiten Quadrats in der Mitte einer Seite des ersten Rechtecks liegt.

## Beschreibung

Die vorliegende Erfindung betrifft eine Leiterplatte für Kraftfahrzeugbeleuchtungseinrichtungen nach dem Oberbegriff des Anspruchs 1.

Eine solche Leiterplatte weist einen Schichtstapel auf, der eine erste Metallschicht, eine darauf liegende erste dielektrische Schicht, eine darauf liegende zweite Metallschicht, eine darauf liegende zweite dielektrische Schicht und eine darauf liegende dritte Metallschicht aufweist, wobei die dritte Metallschicht dazu eingerichtet ist, auf ihr angeordnete Leuchtdioden elektrisch zu kontaktieren und in den Leuchtdioden entstehende Wärme aufzunehmen, wobei die Leiterplatte erste metallische Durchkontaktierungen aufweist, welche die dritte Metallschicht thermisch mit der zweiten Metallschicht verbinden, und zweite metallische Durchkontaktierungen aufweist, welche die zweite Metallschicht thermisch mit der ersten Metallschicht verbinden.

Eine Leiterplatte mit einer solchen Schichtfolge ist aus der US 2009/0154513 A1 bekannt. Allerdings gibt diese Schrift keine Hinweise auf eine Verwendung der Leiterplatte in Kraftfahrzeugbeleuchtungseinrichtungen. Die dielektrische Schicht ist dort in einem Ausführungsbeispiel eine Flame-Retardant-4 (FR4) Schicht, zu deren Zusammensetzung in der genannten Schrift aber nichts offenbart wird.

In Kraftfahrzeugbeleuchtungseinrichtungen eingesetzte Leuchtdioden erzeugen große Lichtströme und damit auch große Joule'sche Verlustleistungen, die in Form von Wärme in den Chips der Leuchtdioden frei werden und die dann über die Leiterplatte abgeleitet werden müssen, um eine Selbstzerstörung der Chips durch Überhitzung zu verhindern. Der Vorgang der Wärmeableitung aus den Leuchtdioden wird auch als Entwärmung bezeichnet.

Kraftfahrzeugbeleuchtungseinrichtungen sind im Alltagsbetrieb vielfältigen Belastungen durch Vibrationen und wechselnde Temperaturen ausgesetzt, so dass in ihnen angeordnete Leiterplatten besonders robust sein müssen. Gleichzeitig müssen Sie eine gute Entwärmung der auf ihnen angeordneten, Wärme erzeugenden Bauteile ermöglichen. Dadurch ergibt sich ein Zielkonflikt, da die Robustheit in der Regel mit dielektrischen Schichten erzielt wird, die schlechte Wärmeleiter sind, und da ein Kühlkörper in der Regel auf einer der Bauelementseite der Leiterplatte gegenüberliegenden Seite der Leiterplatte angeordnet ist. Insbesondere bei oberflächenmontierbaren Bauelementen ist eine ausreichende Kühlung wichtig. Kleinste Bauelemente wie Halbeiterlichtquellen in Form von Leuchtdioden oder Laserdioden enthalten häufig keine separaten thermischen Anschlüsse zur Entwärmung, sondern nur Fußpunkte für die Anschlüsse von Anode und Kathode.

Vor diesem Hintergrund besteht die Aufgabe der vorliegenden Erfindung in der Angabe einer Leiterplatte der eingangs genannten Art, die robust ist und die eine elektrische Verlustwärme von Leuchtdioden, welche mit den für Kraftfahrzeugbeleuchtungseinrichtungen erforderlichen elektrischen Leistungen und damit verbundenen Verlustwärmen arbeiten, effektiv ableitet.

Diese Aufgabe wird mit den Merkmalen des Anspruchs 1 gelöst. Die vorliegende Erfindung unterscheidet sich damit von dem eingangs genannten Stand der Technik dadurch, dass jeweils fünf erste Durchkontaktierungen und vier zweite Durchkontaktierungen in einem ersten Muster angeordnet sind, bei dem vier erste Durchkontaktierungen Eckpunkte eines ersten Rechtecks bilden, das in einer zur Stapelrichtung senkrechten Ebene liegt, die fünfte der ersten Durchkontaktierungen im Schnittpunkt der Diagonalen des ersten Rechtecks liegt, und dass die vier zweiten Durchkontaktierungen auf den Eckpunkten eines zweiten Rechtecks liegen, wobei jeweils ein Eckpunkt des zweiten Quadrats in der Mitte einer Seite des ersten Quadrats liegt.

Durch diese Merkmale wird eine Leiterplatte für Kraftfahrzeugbeleuchtungseinrichtungen bereitgestellt, die sich durch eine hohe mechanische Festigkeit und Robustheit auszeichnet und die eine effektive Wärmeableitung ermöglicht.

Die hohe mechanische Festigkeit ergibt sich durch den Schichtaufbau und insbesondere durch die erste dielektrische Schicht, die gewissermaßen einen stabilen Kern der Leiterplatte bildet.

Die effektive Wärmeableitung ergibt sich durch das Zusammenwirken der zweiten Metallschicht mit dem beanspruchten Muster der Durchkontaktierungen. Durch die Verbindung der dritten Metallschicht mit der zweiten Metallschicht kann Wärme schnell vom Entstehungsort in einem an die dritte Metallschicht thermisch angeschlossenen elektrischen oder elektronischen Bauteil in die zweite Metallschicht geleitet werden. Durch die Verbindung der zweiten Metallschicht mit der ersten Metallschicht kann die von der zweiten Metallschicht aufgenommene Wärme dann in die erste Metallschicht und von dort letztlich an einen Kühlkörper abgeführt werden. Die zweite Metallschicht hat dabei die Funktion eines Zwischenspeichers, der aufgrund seiner Lage im Schichtstapel nahe an der Wärmequelle liegt, was eine schnelle Ableitung der Wärme begünstigt und unerwünschte Temperaturspitzen in den Bauteilen dämpft.

Dadurch, dass die vier zweiten Durchkontaktierungen auf Eckpunkten eines zweiten Rechtecks liegen, wobei jeweils ein Eckpunkt des zweiten Rechtecks auf einer Mitte einer Seite des ersten Rechtecks liegt, ergibt sich in einer zur Stapelrichtung und damit zu den Längsachsen der hülsenförmigen Durchkontaktierungen senkrechten Ebene eine gegenüber den ersten Durchkontaktierungen versetzte Lage der zweiten Durchkontaktierungen. Dadurch wird verhindert, dass eine erste Durchkontaktierung, auf das nicht mit Metall gefüllte Innere einer hülsenförmigen zweiten Durchkontaktierung trifft, was den thermischen Kontakt einer solchen ersten Durchkontaktierung zu der zweiten Metallschicht deutlich verschlechtern würde.

Bei einer vorgegebenen Größe des ersten Rechtecks und einer vorgegeben Anzahl der Durchkontaktierungen hat die beschriebene Anordnung den weiteren Vorteil, dass der kleinste Abstand zwischen einer ersten Durchkontaktierung und einer zweiten Durchkontaktierung so groß ist wie die Hälfte der Länge der kürzeren Rechteckseite. Dieser Abstand ist ein Mindestabstand, der in der beanspruchten Anordnung von keinem möglichen Paar einer ersten Durchkontaktierung und einer zweiten Durchkontaktierung unterbrochen wird, was den Vorteil hat, dass das im vorhergehenden Absatz beschriebene, nachteilige Aufeinandertreffen einer ersten und einer zweiten Durchkontaktierung auch bei einer mit Toleranzen behafteten Herstellung mit hoher Wahrscheinlichkeit vermieden wird.

Darüber hinaus hat die beanspruchte Anordnung den Vorteil, dass sich auf einem vorgegebenen, kleinen Bereich der Leiterplatten ein vergleichsweise großer wärmeleitender Metallquerschnitt der Durchkontaktierungen unterbringen lässt. Diese Bereiche haben zum Beispiel eine Fläche in der Größenordnung der Fläche eines elektrischen Anschlusses eines Bauteils, was zum Beispiel ein Quadratmillimeter sein kann. Die Erfindung ist aber nicht auf solch kleine Flächen beschränkt. Der Flächenbedarf zur Unterbringung eines einzelnen Kreisringquerschnitts einer Durchkontaktierung ist zum Beispiel deutlich größer als der Flächenbedarf zur Unterbringungen von zwei Kreisringquerschnitten gleicher Ringbreite (= Hülsenwandstärke) mit halb so großem Durchmesser.

Für die Wärmetransportfähigkeit kommt es auf den Metallquerschnitt in der zur gewünschten Wärmetransportrichtung senkrechten Ebene an. Je größer der Querschnitt ist, desto größer ist die Wärmetransportfähigkeit.

Die erfindungsgemäße Anordnung der Durchkontaktierungen ergibt einen großen wärmeleitenden Gesamtquerschnitt der Durchkontaktierungen bei kleinem Flächenbedarf, was eine effektive Entwärmung von kleinen Anschlüssen begünstigt.

Durch die Erfindung wird für senkrecht zur Stapelrichtung senkrecht liegende Ebenen eine Anordnung von Durchkontaktierungen angegeben, die mehrere thermisch vergleichsweise gut leitende Schichten über zwischen den thermisch gut leitenden Schichten liegende und vergleichsweise schlecht Wärme leitende Schichten thermisch leitend miteinander verbinden. Damit wird eine thermische Anbindung auch von Anschlussflächen kleinster oberflächenmontierbarer Bauelemente bei minimaler Flächennutzung der Leiterplattenoberfläche sichergestellt.

Es geht dabei nicht um eine elektrische oder sogar automatische Entflechtung von stromführenden Leiterbahnen auf und in einer Leiterplatte. Es geht vielmehr um eine Anordnung, bzw. ein Muster von Durchkontaktierungen zur schnellstmöglichen Entwärmung von Bauelement-Anschlussflächen an der Oberfläche der Leiterplatte, welche die Bestückungsseite darstellt, und um eine schnelle Wärmedurchleitung durch die Leiterplatte hindurch zu der der Bestückungsseite gegenüberliegenden Seite der Leiterplatte, die in der Regel thermisch mit einem Kühlkörper verbunden ist.

In einer bevorzugten Ausgestaltung besitzen die ersten Durchkontaktierungen und die zweiten Durchkontaktierungen verschieden große Metallquerschnitte in einer zur Stapelrichtung senkrechten Ebene.

Bevorzugt ist auch, dass die ersten Durchkontaktierungen (jeweils einzeln) einen kleineren Metallquerschnitt aufweisen als die zweiten Durchkontaktierungen (jeweils einzeln).

Die Anordnung von im Metallquerschnitt kleinen und großen Durchkontaktierungen ist so kompakt, dass sich bezogen auf die kleinste Flächeneinheit, in der eine solche Anordnung, beziehungsweise ein solches Muster liegt, ein maximaler Wärmestrom ergibt. Eine bislang ungeordnete Anordnung von "vias in pad", also von Durchkontaktierungen im Lötfußpunkt, wird durch die Erfindung in eine geordnete Anordnung überführt, die unter der diskutierten Randbedingungen die kleinste Fläche auf der leitenden Schicht belegt. Insgesamt erhöht sich die Packungsdichte der Durchkontaktierungen und damit des leitenden Metallanteils im Vergleich zu ungeordneten Anordnungen. Letztendlich lassen sich damit mehr Bauelemente nebeneinander platzieren.

In einer besonders bevorzugten Ausgestaltung ist das erste Rechteck ein erstes Quadrat und das zweite Rechteck ist ein zweites Quadrat.

Bei dieser Ausgestaltung ergibt sich ein maximaler Quotient aus der leitenden Querschnittsfläche des Musters der Durchkontaktierungen und der Gesamtfläche des Musters im Vergleich anderen Anordnungen der gleichen Durchkontaktierungen. Mit der zusätzlichen Festlegung eines minimalen Abstandes zwischen einer ersten Durchkontaktierung und einer zweiten Durchkontaktierung ergibt sich für eine vorgegebene leitende Querschnittsfläche ein minimaler Flächenbedarf in den zur Stapelrichtung senkrechten Schichtebenen. Bei vorgegebener Fläche für ein solches Muster ergibt sich damit eine maximale Wärmeleitungsfähigkeit.

Eine weitere bevorzugte Ausgestaltung zeichnet sich dadurch aus, dass die ersten Durchkontaktierungen eines Musters so angeordnet sind, dass ihr in der dritten Metallschicht liegendes Ende in einem Fußabdruck eines dort zu montierenden Bauteils liegt. Genau genommen liegt die senkrecht zur Musterebene erfolgende Projektion des Musters in dem Fußpunkt.

Bevorzugt ist auch, dass die Seitenlänge des größeren Rechtecks maximal 2 mm, insbesondere maximal 1,5 mm, insbesondere maximal 1 mm groß ist.

Ferner ist bevorzugt, dass die Durchkontaktierungen mit einer Metallisierung versehene Bohrungen sind.

Eine weitere bevorzugte Ausgestaltung zeichnet sich dadurch aus, dass die Metallisierung der Bohrungen aus dem Metall besteht, aus dem auch die zu verbindenden Metallschichten bestehen, also insbesondere bevorzugt aus Kupfer oder einer Kupfer aufweisenden Legierung.

Bevorzugt ist auch, dass die Schichtdicke der Metallisierung der Bohrungen kleiner als der Radius der Bohrung ist, so dass sich hülsenartige metallische Durchkontaktierungen ergeben.

Ferner ist bevorzugt, dass die erste Metallschicht aus Kupfer oder einer Kupfer aufweisenden Legierung besteht.

Eine weitere bevorzugte Ausgestaltung zeichnet sich dadurch aus, dass die erste dielektrische Schicht und die zweite dielektrische Schicht jeweils eine FR4-Schicht aus einem faserverstärkten aushärtenden Harz oder eine CEM-3 Schicht ist.

Bevorzugt ist auch, dass die zweite Metallschicht genauso dick wie die erste Metallschicht ist.

Ferner ist bevorzugt, dass die zweite Metallschicht aus dem gleichen Metall wie die erste Metallschicht und die erste Metallschicht besteht.

Eine weitere bevorzugte Ausgestaltung zeichnet sich dadurch aus, dass die zweite dielektrische Schicht maximal 100 µm dick ist.

Bevorzugt ist auch, dass die dritte Metallschicht dünner als die erste Metallschicht und auch dünner als die zweite Metallschicht ist.

Weitere Vorteile ergeben sich aus der nachfolgenden Beschreibung, den Zeichnungen und den Unteransprüchen. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Wenn im Folgenden von einer Kupferlage oder Kupferschicht die Rede ist, soll damit jeweils sowohl reines Kupfer als auch eine Kupferlegierung gemeint sein.

Ausführungsbeispiele der Erfindung sind in den Zeichnungen dargestellt und werden in der nachfolgenden Beschreibung näher erläutert.

Dabei zeigen, jeweils in schematischer Form:
- Figur 1: eine Schrägansicht einer mit einer Leuchtdiode bestückten Leiterplatte zusammen mit einem Kühlkörper;
- Figur 2: einen Querschnitt durch ein Ausführungsbeispiel einer erfindungsgemäßen Leiterplatte;
- Figur 3: ein Muster von erfindungsgemäß angeordneten Durchkontaktierungen;
- Figur 4: dem Muster der Figur 3 zugrunde liegende geometrische Formen; und
- Figur 5: ein weiteres Ausführungsbeispiel von erfindungsgemäß angeordneten Durchkontaktierungen.

Dabei bezeichnen gleiche Bezugszeichen in verschiedenen Figuren jeweils gleiche oder zumindest ihrer Funktion nach vergleichbare Elemente.

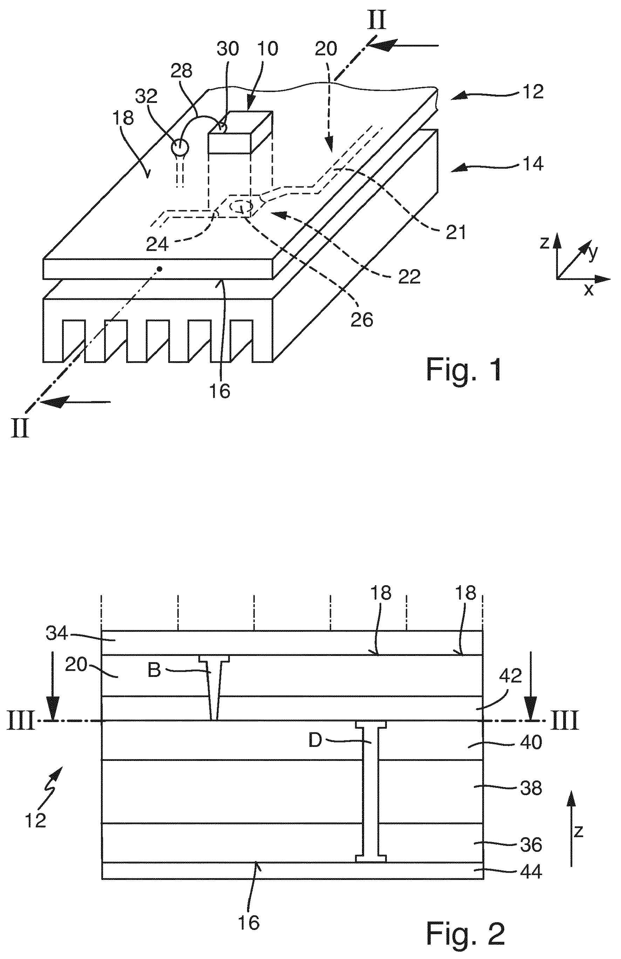

Im Einzelnen zeigt die Figur 1 eine Schrägansicht einer mit einem elektrischen oder elektronischen Bauelement 10 bestückten Leiterplatte 12 zusammen mit einem Kühlkörper 14. Das Bauelement 10 ist bevorzugt eine Leuchtdiode. Die Leiterplatte 12 und der Kühlkörper 14 sind in der Figur 1 durch einen Abstand getrennt voneinander dargestellt. Sie werden bei der Verwendung der Leiterplatte in einer Beleuchtungseinrichtung eines Kraftfahrzeugs jedoch zu einer Baugruppe zusammengefügt sein, in welcher der Kühlkörper 14 die Unterseite 16 der Leiterplatte 12 thermisch kontaktiert, um Wärme aus der Leiterplatte 12 aufzunehmen und an die Umgebung abzugeben.

Die Leiterplatte 12 weist zusätzlich zu der dem Kühlkörper 14 zugewandten Unterseite 16 eine dem Kühlkörper abgewandte und mit Bauelementen 10 bestückte Oberseite 18 auf. Im dargestellten Beispiel ist eine einzelne Leuchtdiode als Bauelement 10 dargestellt. Im Normalfall wird eine Leiterplatte 12, die für eine Verwendung in einer Beleuchtungseinrichtung eines Kraftfahrzeuges bestimmt ist, mit mehr als einer Leuchtdiode und ggf. auch weiteren Bauelementen 10 bestückt sein, was hier lediglich aus Gründen der Übersichtlichkeit nicht dargestellt ist. Die Begriffe Oberseite und Unterseite beziehen sich hier nur auf die Darstellung in den Figuren 1 und 2 und sollen nicht als einschränkende Orientierungsmerkmale verstanden werden. Es versteht sich, dass die Leiterplatte auch in anderen Orientierungen verwendet werden kann, zum Beispiel in einer Orientierung, in der die Seite 18 eine rechte (linke, oder untere) Seite und die Seite 16 eine linke (rechte, oder obere) Seite sein kann.

Die Seite 18 der Leiterplatte ist mit einer metallischen Schicht 20 versehen, die in der Ebene der Seite 18 strukturiert ist, wobei die strukturierte Schicht 20 insbesondere Leiterbahnen 21 zur elektrischen Kontaktierung der Bauelemente 10, Anschlusspads 24 zur elektrischen und gegebenenfalls ergänzend auch thermischen Kontaktierung der Bauelemente 10 und gegebenenfalls nur zur thermischen Kontaktierung der Bauelemente 10 dienende weitere Anschlusspads 26 aufweist. Die Anschlusspads 24 und 26 befinden sich bevorzugt in einem Fußabdruck 22 des Bauteils 10 auf der Oberseite der Leiterplatte, wobei unter dem Fußabdruck hier die Fläche verstanden wird, die von dem Bauteil 10 nach dessen Montage auf der Leiterplatte 12 eingenommen wird.

Alternativ oder ergänzend kann die thermische und/oder elektrische Kontaktierung auch über Bonddrähte 28 erfolgen, mit denen außerhalb der Leiterplatten-Oberseiten-Ebene liegende Anschlüsse 30 der Bauteile 10 mit in der Oberseite und außerhalb des Fußabdrucks 22 liegenden Anschlusspads 32 verbunden sind, die ebenfalls Bestandteile der metallischen Schicht 20 sind. Die Oberseite 18 und die Unterseite 16 sind parallel zur x-y-Ebene eines mit der Leiterplatte 12 verankerten rechtshändigen, kartesischen Koordinatensystems angeordnet. Die Dicke der Leiterplatte 12 entspricht dem Abstand der Oberseite 18 von der Unterseite 16 der Leiterplatte 12 und liegt parallel zur z-Richtung des genannten Koordinatensystems.

Die Metallschicht 20 ist eine dritte Metallschicht und ist im einsatzfertigen Zustand dazu eingerichtet, auf ihr angeordnete Bauelemente 10, insbesondere Leuchtdioden, elektrisch und thermisch zu kontaktieren. Dazu dienen die Leiterbahnen 21 und Anschlusspads 24, 26, 32, die sich als Folge der Strukturierung der dritten Metallschicht 20 in voneinander getrennte lineare und flächige Strukturen ergeben. Die Strukturierung erfolgt z.B. durch Lithografie- und Ätz-Techniken. Die Anschlusspads 26, 32 werden bei der Fertigung z.B. mit einem festen, aber aufschmelzbaren Lötmittel versehen. Dann werden die Leuchtdioden mit ihren elektrischen Anschlüssen auf die Pads aufgesetzt, und das Lötmittel wird aufgeschmolzen, so dass sich eine elektrisch leitfähige Verbindung zwischen auf der Leiterplatte verlaufenden Leiterbahnen der Leiterplatte und /oder in die Tiefe der Leiterplatte hinabreichenden Durchkontaktierungen auf der einen Seite und dem jeweiligen Bauteil auf der anderen Seite ergibt.

Die im Betrieb im Bauteil 10, also insbesondere im Chip einer Leuchtdiode frei werdende Verlustwärme wird über die zur elektrischen und thermischen Kontaktierung dienenden Anschlusspads 24 und/oder über Bonddrähte 28 und/oder über die nur zur Entwärmung dienenden Anschlusspads 26 dieser Leuchtdiode in die Leiterplatte eingeleitet und durch im Folgenden noch zu erläuternde Strukturen zur Unterseite 16 der Leiterplatte geleitet. Die Unterseite 16 ist beim Einsatz der Leiterplatte in der Beleuchtungseinrichtung bevorzugt thermisch mit dem Kühlkörper 14 verbunden, der diese Wärme aufnimmt und an die Umgebung abführt.

Die Figur 2 zeigt im Einzelnen einen Schichtstapel aus einer ersten Metallschicht 36, einer daran haftend anliegenden ersten dielektrischen Schicht 38, einer daran haftend anliegenden zweiten Metallschicht 40, einer daran haftend anliegenden zweiten dielektrischen Schicht 42 und einer daran haftend anliegenden dritten Metallschicht 20.

Die erste Metallschicht 36 bildet mit einer ihrer zwei ausgedehnten Schichtflächen die Seite/Unterseite 16 dieses Schichtstapels. Der Kühlkörper 14 wird mit der Unterseite 16 bevorzugt über eine Schicht 44 verbunden, die elektrisch isoliert, aber thermisch gut leitfähig ist und die z.B. aus Lötstopplack besteht. Die Dicke der ersten Metallschicht 36 beträgt bevorzugt 84 bis 254 µm. Sie besteht bevorzugt aus Kupfer oder einer Kupfer aufweisenden Legierung.

Die erste dielektrische Schicht 38 bildet einen Kern der Leiterplatte 12, welcher der Leiterplatte ihre mechanische Stabilität verleiht. Bei der ersten dielektrischen Schicht 38 handelt es sich bevorzugt um eine FR4-Schicht aus einem faserverstärkten aushärtenden Harz, insbesondere um ein mit einem solchen Harz gefülltes, verwebtes Glasfasergeflecht. Alternativ kann es sich auch um eine CEM-3 Schicht handeln. Die auf der ersten dielektrischen Schicht 38 aufliegende zweite Metallschicht 40 ist bevorzugt 84 bis 254 µm dick. Sie ist insbesondere bevorzugt genauso dick wie die erste metallische Schicht 36. Sie besteht bevorzugt aus dem gleichen Metall wie die erste Metallschicht 36, insbesondere aus Kupfer oder einer Kupfer aufweisenden Legierung.

Auf der zweiten Metallschicht 40 liegt die zweite dielektrische Schicht 42 anhaftend auf. Bei der zweiten dielektrischen Schicht 42 handelt es sich bevorzugt um eine FR4-Schicht aus einem faserverstärkten aushärtenden Harz. Es handelt sich auch hier bevorzugt um ein mit Harz gefülltes, verwebtes Glasfasergeflecht. Alternativ handelt es sich um eine CEM-3 Schicht. Die zweite dielektrische Schicht 42 ist bevorzugt maximal 100 µm dick. Die dritte Metallschicht 20 ist zunächst bevorzugt eine Metallfolie von 20 bis 25 µm Dicke. Die Metallschicht 20 ist bevorzugt insbesondere dünner als die erste Metallschicht und auch dünner als die zweite Metallschicht. Die zweite Metallschicht besteht bevorzugt aus Kupfer oder einer Kupfer aufweisenden Legierung. Die dritte Metallschicht 20 wird bei der Fertigung der Leiterplatte 12 bevorzugt auf den übrigen Schichtstapel aufgepresst und später so strukturiert, dass sich die oben genannten Anschlusspads und Leiterbahnen ergeben.

Die Leiterplatte 12 weist erste metallische Durchkontaktierungen B auf, welche die dritte Metallschicht 20 thermisch mit der zweiten Metallschicht 40 verbinden. Die Leiterplatte weist ferner zweite metallische Durchkontaktierungen D auf, welche die zweite Metallschicht 40 thermisch mit der ersten Metallschicht 36 verbinden. Die Durchkontaktierungen sind mit einer Metallisierung versehene Bohrungen. Die Metallisierung besteht bevorzugt aus dem Metall, aus dem auch die zu verbindenden Metallschichten bestehen, also insbesondere bevorzugt aus Kupfer oder einer Kupfer aufweisenden Legierung. Die Schichtdicke der Metallisierung der Bohrungen ist bevorzugt kleiner als der Radius der Bohrung, so dass sich hülsenartige metallische Durchkontaktierungen ergeben.

Die der Oberseite 18 zugewandte dritte Metallschicht 20 ist im Endzustand in Anschlusspads und Leiterbahnen strukturiert, wobei die Strukturierung durch Lithografieschritte und Ätzschritte erfolgen kann. Die Entwärmung der auf der Leiterplatte angeordneten Bauteile, insbesondere der Leuchtdioden, erfolgt über ihre dafür vorgesehenen Anschlusspads. Wärme, die im Betrieb einer Leuchtdiode in ihrem Halbleiterchip frei wird, fließt über das jeweilige Anschlusspad zunächst in die dritte Metallschicht 20 und wird von dort über die ersten Durchkontaktierungen vom Typ B schnell abgeführt. Dabei dient die zweite Metallschicht 40 gewissermaßen als Puffer, der schnell Wärme aufnehmen und in seiner Fläche verteilen kann. Die Fähigkeit zur schnellen Wärmeaufnahme ergibt sich dabei daraus, dass dieser Puffer wegen der geringen Dicke der zweiten dielektrischen Schicht 42 sehr dicht an den Leuchtdioden/Bauteilen liegt. Dadurch wird einer Entstehung unerwünschter lokaler Temperaturspitzen effektiv entgegengewirkt.

Von der zweiten Metallschicht 40 wird die dort aufgenommene Wärme über die zweiten Durchkontaktierungen vom Typ D zur ersten Metallschicht 36 geleitet, wobei die erste dielektrische Schicht 38 thermisch lokal überbrückt wird.

Die Anordnung von Durchkontaktierungen eignet sich sowohl zur Entwärmung von Anschlusspads, die nur der Entwärmung dienen, als auch von Anschlusspads, die auch ein elektrisches Potenzial besitzen. Herrscht auf dem zu erwärmenden Anschlusspad ein elektrisches Potential, muss die erste Metallschicht 36 und die zweite Metallschicht 40 ggf. in Leiterbahnen strukturiert werden, so wie es bei der dritten Metallschicht 20 der Fall ist, um elektrische Kurzschlüsse zwischen verschiedenen Pads der gleichen Leuchtdiode oder verschiedenen Pads von verschiedenen Leuchtdioden zu vermeiden.

Im Folgenden wird die Herstellung eines Ausführungsbeispiels einer erfindungsgemäßen Leiterplatte 12 erläutert.

Die erste dielektrische Schicht 38 ist bevorzugt ein Bestandteil eines kupferkaschierten Halbfertigprodukts, wobei die erste dielektrische Schicht 38 zwischen einer oberen Kupferschicht und einer unteren Kupferschicht eingebettet ist. Das dielektrische Kernmaterial weist bevorzugt eine Dicke von 700, 1000, 1200 oder 1550 µm Dicke auf. Die obere Kupferschicht und die untere Kupferschicht weist bevorzugt jeweils eine Dicke von 70 bis 210 µm auf. Das kupferkaschierte Halbfertigprodukt wird zunächst so stark erwärmt, dass das Harz aushärtet. Dann werden an den Stellen, an denen später die Durchkontaktierungen liegen sollen, Löcher gebohrt. Diese Löcher haben in einer bevorzugten Ausgestaltung einen Durchmesser von 0,25 mm. Die Löcher werden mechanisch gebohrt. In einem anschließenden Metallisierungsschritt, der bevorzugt durch ein Metallisierungsbad erfolgt, werden die Innenflächen der Bohrungen mit Metall belegt. Bei dem Metall handelt es sich bevorzugt um das gleiche Metall wie beim Material der ersten Metallschicht und/oder der zweiten Metallschicht. Es handelt sich also insbesondere bevorzugt um Kupfer oder einer Kupfer aufweisenden Legierung. Die Dicke der Metallisierung beträgt in den Bohrungen bevorzugt 20 bis 25 µm. Der verbleibende Hohlraum der so entstandenen Hülsen wird bevorzugt mit dielektrischem Harz gefüllt.

In diesem Zusammenhang sei an die in der zur Stapelrichtung zueinander versetzte Anordnung der ersten Durchkontaktierungen und der zweiten Durchkontaktierungen erinnert, die verhindert, dass eine Durchkontaktierung vom Typ B auf der Harzfüllung einer Durchkontaktierung vom typ D endet. Durch ein Auftreffen auf die Harzfüllung würde der Wärmefluss wegen der im Vergleich zum Metall der Durchkontaktierungen viel schlechteren Wärmeleitfähigkeit des Harzes praktisch unterbrochen.

Bei der Metallisierung der Bohrung scheidet sich auch Metall auf der ersten Metallschicht und der zweiten Metallschicht des Halbfertigprodukts ab, so dass sich die Dicke der jeweiligen Metallschichten vergrößert. Im Ergebnis beträgt die Dicke der ersten Metallschicht 36 und der zweiten Metallschicht 40 bevorzugt mehr als jeweils 84 µm. Auf diese Art und Weise werden Durchkontaktierungen vom Typ D, welche nur die erste Metallschicht thermisch mit der zweiten Metallschicht verbinden, erzeugt. Auf den so prozessierten Kern wird anschließend die zweite dielektrische Schicht 42 mit maximal 100 µm Dicke aufgebracht.

Die zweite dielektrische Schicht 42 ist bevorzugt ein sog. Prepreg, also ein harzgefülltes, verwebtes Glasfasergeflecht. Anschließend wird darauf eine Metallfolie, insbesondere eine Kupferfolie von bevorzugt 18 bis 35 µm Dicke als dritte Metallschicht 20 aufgebracht. Die dritte Metallschicht kann in mehreren Schritten aufgebaut werden.

Die thermische Anbindung der dritten Metallschicht 20 an die zweite Metallschicht 40 erfolgt durch erste Durchkontaktierungen vom Typ B. Dazu werden bevorzugt Löcher gebohrt, und in einem Metallisierungsschritt werden diese Löcher mit einer Metallisierung versehen, wie es weiter oben bereits für die Verbindung der zweiten Metallschicht 40 und der ersten Metallschicht 36 beschrieben worden ist.

Die Löcher werden entweder mechanisch gebohrt oder mit einem Laser erzeugt. Die Löcher sind bevorzugt kleiner als die Löcher, die für die Durchkontaktierungen D verwendet werden, mit denen die zweite Metallschicht 40 thermisch mit der ersten Metallschicht 20 verbunden wird. Die Löcher haben bevorzugt einen Durchmesser von 0,12 mm und werden galvanisch mit einer Metallschicht von 12 µm Stärke belegt. Auch hier gilt, dass die Schichtdicke der dritten Metallschicht 20 durch die Metallisierung zunimmt.

Bei einem bevorzugten Ausführungsbeispiel einer erfindungsgemäßen Leiterplatte wird auf eine von zwei vergleichsweise dicken Kupferlagen, die durch ein Dielektrikum getrennt sind, ein weiteres Dielektrikum mit einer weiteren Kupferlage aufgebracht. Diese weitere Kupferlage weist eine im Vergleich zu der Dicke der zwei vergleichsweise dicken Kupferlagen geringere Dicke auf. Die geringere Dicke beträgt bevorzugt ungefähr 1 Zehntel bis ein Viertel der Dicke der vergleichsweis dickeren Kupferlagen. Die vergleichsweise weniger dicke Kupferlage ist mit bevorzugt lasergebohrten oder mechanisch gebohrten Durchkontaktierungen thermisch mit den beiden vergleichsweise dicken Kupferlagen verbunden. Bevorzugt sind auch die beiden dicken Kupferlagen durch solche Durchkontaktierungen miteinander verbunden. Es sind stets drei elektrisch und thermisch leitende Lagen (Metallschichten) vorhanden.

Durchkontaktierungen vom Typ B, welche in der dritten Metallschicht 20 enden, sind bevorzugt so angeordnet, dass ihr Ende in einem Fußabdruck eines dort zu montierenden Bauteils liegt. Vergleiche Figur 2. Dies spart Platz und ist manchmal, nämlich bei einer hohen Packungsdichte von Bauteilen und / oder Leiterbahnen auf der Leiterplatte, auch die einzige Möglichkeit, wärmeerzeugende Bauteile wie Leuchtdioden zu entwärmen.

Die erfindungsgemäße Leiterplatte ermöglicht einen schnellen Abfluss von Wärme aus dem Bauteil in die zweite Metallschicht 40, die als Puffer und Wärmesenke dient und ihrerseits die aufgenommene Wärme über die Durchkontaktierungen zur ersten Metallschicht und damit letztlich zum Kühlkörper weitergibt. Das relativ dicke Kernmaterial aus der ersten Metallschicht, der ersten dielektrischen Schicht und der zweiten Metallschicht gewährleistet eine vorteilhaft hohe Verwindungssteifigkeit. Die erfindungsgemäße Leiterplatte bietet die Vorteile einer Material- und einer Zeitersparnis bei der Produktion. Außerdem bietet die Erfindung den Vorteil einer effektiven und schnellen Entwärmung von sehr kleinen Bauelementen wie Leuchtdioden in Kraftfahrzeugbeleuchtungseinrichtungen.

Die Erfindung ist nicht auf den beschriebenen Schichtaufbau beschränkt. In einer bevorzugten Ausgestaltung ist die Schichtfolge in der Leiterplatte symmetrisch zu einer Mittelebene der ersten dielektrischen Schicht 38, wobei die Symmetrieebene senkrecht zur Stapelrichtung ist. Die Stapelrichtung ist in der Figur 2 parallel zur z-Richtung. Die in diesem Fall zwischen der ersten Metallschicht 36 und der elektrisch bevorzugt isolierenden und thermisch obligatorisch gut leitenden Schicht 44 liegenden Schichtfolge aus einer weiteren, der zweiten dielektrischen Schicht 42 entsprechenden dielektrischen Schicht und einer weiteren, der dritten Metallschicht 20 entsprechenden Metallschicht werden bevorzugt ebenfalls mit ersten Durchkontaktierungen vom Typ B versehen.

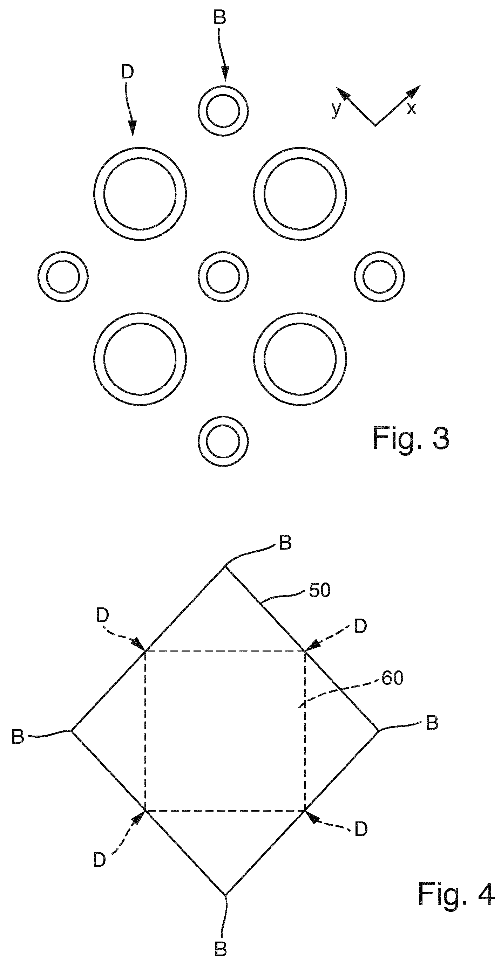

Die Figur 3 zeigt einen Ausschnitt einer Draufsicht auf die zweite Metallschicht 40, also einen Schnitt durch den Schichtstapel mit einer zur Stapelrichtung senkrechten Schnittfläche, in der Höhe der den ersten Durchkontaktierungen B zugewandten Seite der Metallschicht 20. In dieser Schnittfläche enden sowohl die ersten Durchkontaktierungen vom Typ B als auch die zweiten Durchkontaktierungen vom Typ D.

Der Ausschnitt zeigt insbesondere ein Muster von ersten und zweiten Durchkontaktierungen in einer erfindungsgemäßen Anordnung. Das Muster befindet sich zum Beispiel direkt unterhalb des Anschlusspads 26 oder der Anschlusspads 24 oder 32 aus der Figur 1. Die Figur 3 zeigt insbesondere ein Muster aus fünf ersten Durchkontaktierungen B und vier zweiten Durchkontaktierungen D. Vier der fünf ersten Durchkontaktierungen bilden in der Schnittebene Eckpunkte eines ersten Rechtecks, hier eines Quadrates. Das Rechteck liegt damit in einer zur Stapelrichtung senkrechten Ebene. Die fünfte der ersten Durchkontaktierungen liegt im Schnittpunkt der Diagonalen des ersten Rechtecks. Die vier zweiten Durchkontaktierungen vom Typ D liegen auf den Eckpunkten eines zweiten Rechtecks. Dabei liegt jeweils ein Eckpunkt des zweiten Quadrats in der Mitte einer Seite des ersten Quadrats.

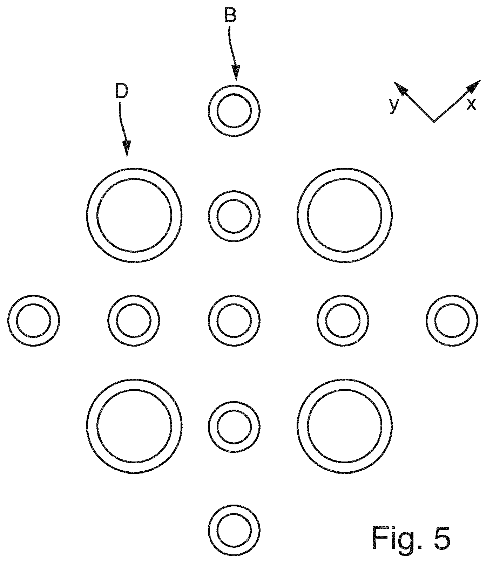

Wie Figur 5 zeigt, bilden die Anordnungen der Mittelpunkte der ersten Durchkontaktierungen vom Typ B und der zweiten Durchkontaktierungen vom Typ D bilden stets zwei Rechtecke 50, 60, insbesondere zwei Quadrate, die verschieden groß sind. Die ersten Durchkontaktierungen B bilden das größere Quadrat 50. Die Ecken des kleineren Quadrats 60 liegen mittig auf den symmetrisch geteilten Seitenlinien des großen Quadrates.

Eine solche Anordnung wird lokal dort verwendet, wo viel Wärme abgeführt werden muss. Für ein thermal pad eines Bauelements wird wenigstens eine, ggf. aber auch mehrere solcher Anordnungen verwendet. Diese müssen dann in der oberen Metallschicht miteinander verbunden sein. Dabei kann die gesamte Fläche der miteinander verbundenen Anordnungen auch größer als ein zu entwärmender Fußpunkt des Bauteils Bauteils sein.

In einer bevorzugten Ausgestaltung besitzen die ersten Durchkontaktierungen und die zweiten Durchkontaktierungen verschieden große Metallquerschnitte in einer zur Stapelrichtung senkrechten Ebene.

Bevorzugt ist auch, dass die ersten Durchkontaktierungen (jeweils einzeln) einen kleineren Metallquerschnitt aufweisen als die zweiten Durchkontaktierungen. Bevorzugt sind die Durchmesser der die ersten Durchkontaktierungen kleiner als die Durchmesser der zweiten Durchkontaktierungen. Alternativ oder ergänzend sind die Wandstärken der ersten Durchkontaktierungen kleiner als die Wandstärken der zweiten Durchkontaktierungen. Beide Merkmale sind in den Figuren 3 und 5 dargestellt.

Figur 5 zeigt einen Ausschnitt einer Draufsicht auf die zweite Metallschicht 40, also einen Schnitt durch den Schichtstapel mit einer zur Stapelrichtung senkrechten Schnittfläche, in der Höhe der den ersten Durchkontaktierungen B zugewandten Seite der Metallschicht 20 für eine Ausgestaltung des Musters der ersten Durchkontaktierungen und der zweiten Durchkontaktierungen. Der einzige Unterschied zu der Ausgestaltung mit fünf ersten Durchkontaktierungen besteht darin, dass die Ausgestaltung gemäß der Figur 5 vier weitere erste Durchkontaktierungen aufweist. Jede der vier weiteren ersten Durchkontaktierungen ist auf einer Diagonale des ersten Rechtecks mittig zwischen einem Eckpunkt und dem Mittelpunkt des ersten Rechtecks angeordnet. Je nach Größe der Querschnitte der ersten Durchkontaktierungen muss das erste und/oder das zweite Rechteck etwas vergrößert werden, um die zusätzlichen vier ersten Durchkontaktierungen unterzubringen, was sich im Größenverhältnis der Muster nach den Figuren 3 und 5 abbildet.

Mit Blick auf die Anordnung der ersten Durchkontaktierungen und der zweiten Durchkontaktierungen ist noch ein weiterer Aspekt von Vorteil: Dieser Aspekt betrifft die Anordnungen der ersten Durchkontaktierungen und der zweiten Durchkontaktierungen. Die ersten Durchkontaktierungen sind vorteilhafterweise relativ zu den zweiten Durchkontaktierungen so angeordnet, dass eine Metallisierung einer zweiten Durchkontaktierung nicht auf einen nicht mit Metall gefüllten Innenraum einer ersten Durchkontaktierung stößt, oder umgekehrt, dass eine Metallisierung einer ersten Durchkontaktierung nicht auf einen nicht mit Metall gefüllten Innenraum einer zweiten Durchkontaktierung stößt.

Diese Forderung ist insbesondere und besonders vorteilhaft dann erfüllt, wenn jeweils fünf erste Durchkontaktierungen B und vier zweite Durchkontaktierungen D in einem Muster angeordnet sind, bei dem vier erste Durchkontaktierungen Eckpunkte eines ersten Rechtecks 50 bilden, das in einer zur Stapelrichtung senkrechten Ebene liegt, die fünfte der ersten Durchkontaktierungen B im Schnittpunkt der Diagonalen des ersten Rechtecks 50 liegt, und dass die vier zweiten Durchkontaktierungen D auf den Eckpunkten eines zweiten Rechtecks 60 liegen, wobei jeweils ein Eckpunkt des zweiten Rechtecks 60 in der Mitte einer Seite des ersten Rechtecks 50 liegt.

Es liegt aber auf der Hand, dass sich diese vorteilhafte Vermeidung einer Unterbrechung eines Wärmeleitungspfades auch mit anderen Anordnungen von ersten Durchkontaktierungen und von zweiten Durchkontaktierungen erfüllen lässt. Beispiele solcher Anordnungen sind zum Kreise, auf denen erste Durchkontaktierungen angeordnet sind, wobei die eine zweiten Durchkontaktierung im Mittelpunkt eines solchen Kreises angeordnet ist. Die ersten Durchkontaktierungen können über den Kreis regelmäßig verteilt sein, so dass sich regelmäßige Vielecke ergeben, oder sie könne ungleichmäßig verteilt sein, wodurch sich ungleichmäßige Vielecke ergeben. Anstelle von Kreisen können auch ellipsenförmige Anordnung verwendet werden, wobei diese Beispiele keine abschließende Aufzählung darstellen sollen. Wesentlich ist jeweils, dass eine Metallisierung einer zweiten Durchkontaktierung nicht auf einen nicht mit Metall gefüllten Innenraum einer ersten Durchkontaktierung stößt, oder umgekehrt, dass eine Metallisierung einer ersten Durchkontaktierung nicht auf einen nicht mit Metall gefüllten Innenraum einer zweiten Durchkontaktierung stößt. Aus Sicht der Anmelderin kommt diesem Aspekt eine eigene erfinderische Qualität zu, der die spezielle Anordnung der Durchkontaktierungen gemäß Anspruch 1 nicht zwingend voraussetzt.

Für alle Ausführungsbeispiele gilt, dass die Anordnungen der ersten Durchkontaktierungen und der zweiten Durchkontaktierungen vertauschbar sind.

## Patentansprüche

1. Leiterplatte (12) für Kraftfahrzeugbeleuchtungseinrichtungen, die einen Schichtstapel aufweist, der eine erste Metallschicht (36), eine darauf liegende erste dielektrische Schicht (38), eine darauf liegende zweite Metallschicht (40), eine darauf liegende zweite dielektrische Schicht (42) und eine darauf liegende dritte Metallschicht (20) aufweist, wobei die dritte Metallschicht dazu eingerichtet ist, auf ihr angeordnete Bauelemente elektrisch zu kontaktieren und in den Bauelementen entstehende Wärme aufzunehmen, wobei die Leiterplatte erste metallische Durchkontaktierungen (B) aufweist, welche die dritte Metallschicht thermisch mit der zweiten Metallschicht verbinden, und zweite metallische Durchkontaktierungen (D) aufweist, welche die zweite Metallschicht thermisch mit der ersten Metallschicht verbinden, **dadurch gekennzeichnet, dass** jeweils fünf erste Durchkontaktierungen (B) und vier zweite Durchkontaktierungen (D) in einem Muster angeordnet sind, bei dem vier erste Durchkontaktierungen Eckpunkte eines ersten Rechtecks (50) bilden, das in einer zur Stapelrichtung senkrechten Ebene liegt, die fünfte der ersten Durchkontaktierungen (B) im Schnittpunkt der Diagonalen des ersten Rechtecks (50) liegt, und dass die vier zweiten Durchkontaktierungen (D) auf den Eckpunkten eines zweiten Rechtecks (60) liegen, wobei jeweils ein Eckpunkt des zweiten Rechtecks (60) in der Mitte einer Seite des ersten Rechtecks (50) liegt.

2. Leiterplatte (12) nach Anspruch 1, **dadurch gekennzeichnet, dass** die Rechtecke Quadrate sind.

3. Leiterplatte (12) nach einem der vorhergehenden Ansprüche, **dadurch gekennzeichnet, dass** die ersten Durchkontaktierungen und die zweiten Durchkontaktierungen verschieden große Metallquerschnitte in einer zur Stapelrichtung senkrechten Ebene besitzen.

4. Leiterplatte (12) nach einem der vorhergehenden Ansprüche, **dadurch gekennzeichnet, dass** die ersten Durchkontaktierungen (B), jeweils einzeln, einen kleineren Metallquerschnitt aufweisen als die zweiten Durchkontaktierungen (D), jeweils einzeln.

5. Leiterplatte (12) nach einem der vorhergehenden Ansprüche, **dadurch gekennzeichnet, dass** die ersten Durchkontaktierungen (B) eines Musters so angeordnet sind, dass ihr in der dritten Metallschicht (20) liegendes Ende in einem Fußabdruck (22) eines dort zu montierenden Bauelements (10) liegt.

6. Leiterplatte (12) nach einem der vorhergehenden Ansprüche, **dadurch gekennzeichnet, dass** die Durchkontaktierungen (B, D) mit einer Metallisierung versehene Bohrungen sind.

7. Leiterplatte (12) nach Anspruch 6, **dadurch gekennzeichnet, dass** die Metallisierung der Bohrungen aus dem Metall besteht, aus dem auch die zu verbindenden Metallschichten bestehen, also insbesondere bevorzugt aus Kupfer oder einer Kupfer aufweisenden Legierung.

8. Leiterplatte (12) nach einem der Ansprüche 6 und 7, **dadurch gekennzeichnet, dass** die Schichtdicke der Metallisierung der Bohrungen kleiner als der Radius der Bohrung ist, so dass sich hülsenartige metallische Durchkontaktierungen ergeben.

9. Leiterplatte (12) nach einem der vorhergehenden Ansprüche, **dadurch gekennzeichnet, dass** die erste Metallschicht (36) aus Kupfer oder einer Kupfer aufweisenden Legierung besteht.

10. Leiterplatte (12) nach einem der vorhergehenden Ansprüche, **dadurch gekennzeichnet, dass** die erste dielektrische Schicht (38) und die zweite dielektrische Schicht (42) jeweils eine FR4-Schicht aus einem faserverstärkten aushärtenden Harz oder eine CEM-3 Schicht ist.

11. Leiterplatte (12) nach einem der vorhergehenden Ansprüche, **dadurch gekennzeichnet, dass** die zweite Metallschicht (40) genauso dick wie die erste Metallschicht (36) ist.

12. Leiterplatte (12) nach einem der vorhergehenden Ansprüche, **dadurch gekennzeichnet, dass** die zweite Metallschicht (40) aus dem gleichen Metall wie die erste Metallschicht (36) und die erste Metallschicht (20) besteht.

13. Leiterplatte (12) nach einem der vorhergehenden Ansprüche, **dadurch gekennzeichnet, dass** die zweite dielektrische Schicht (42) maximal 100 µm dick ist.

14. Leiterplatte (12) nach einem der vorhergehenden Ansprüche, **dadurch gekennzeichnet, dass** die dritte Metallschicht (20) dünner als die erste Metallschicht und auch dünner als die zweite Metallschicht (40) ist.
